# EUROPEAN PATENT APPLICATION

(11) **EP 2 275 348 A2**
(43) Date of publication of application: **19.01.2011**
(21) Application number: 10251257.1
(22) Date of filing: 13.07.2010
(51) Int. Cl.: B64G 1/44, H01L 31/052, H01L 31/045

(54) **Segmented parabolic concentrator for space electric power**

(30) Priority: 13.07.2009 US 502200
(71) Applicant: Hamilton Sundstrand Corporation, Windsor Locks, CT 06096-1010 (US)
(72) Inventor: Wait, David, Westlake Village, CA 91361 (GB)
(74) Representative: Tomlinson, Kerry John

(57) **Abstract**

A segmented parabolic concentrator (30) includes a concave surface (32) which extends from a central support (34) extending from a cell support (36), the concave surface defines a multitude of flat segments.

## Description

### BACKGROUND

The present disclosure relates to an electrical power system for spacecraft, and more particularly to a solar concentrator.

Spacecraft electrical power generation demands continue to increase as mission planners propose additional electrically powered technologies for propulsion, long-range observation, and power beaming. Spacecraft electrical power generation systems are typically measured in terms of power generated and the stowed volume of the system per unit mass. Such measurements may include the mass required to collect the desired sunlight, the mass required to convert the sunlight to electricity by solar cells, the efficiency of solar cells, the support structure required to survive the accelerations during launch, and a layout that facilitates folding of large panels into small volumes.

### SUMMARY

A segmented parabolic concentrator according to an exemplary aspect of the present disclosure includes a central support which extends from a cell support. A concave surface extends from the central support, the concave surface defines a multitude of flat segments.

A wing structure for a spacecraft according to an exemplary aspect of the present disclosure includes a segmented parabolic concentrator which defines a multitude of flat segments, and a concentrator photovoltaic (CPV) array operable to receive reflected sunlight from the segmented parabolic concentrator.

### BRIEF DESCRIPTION OF THE DRAWINGS

Various features will become apparent to those skilled in the art from the following detailed description of the disclosed non-limiting embodiment. The drawings that accompany the detailed description can be briefly described as follows:
Figure 1 is a general schematic view of an exemplary spacecraft for use with the present disclosure;
Figure 2 is an expanded schematic view of a wing structure of the spacecraft;
Figure 3 is a sectional view of a segmented parabolic concentrator;
Figure 4 is an end view of the segmented parabolic concentrator illustrating a fiber direction;
Figure 5 is a schematic view of the segmented parabolic concentrator adjacent to a support structure;
Figure 6 is a sectional view of the segmented parabolic concentrator illustrating a dimensional relationship of the multitude of flat segments;
Figure 7 is a schematic view of sunlight reflected from the segmented parabolic concentrator to the CPV array; and
Figure 8 is a graphical representation of the sunlight reflected by each of the multitude of flat segments of the segmented parabolic concentrator to the CPV array.

### DETAILED DESCRIPTION

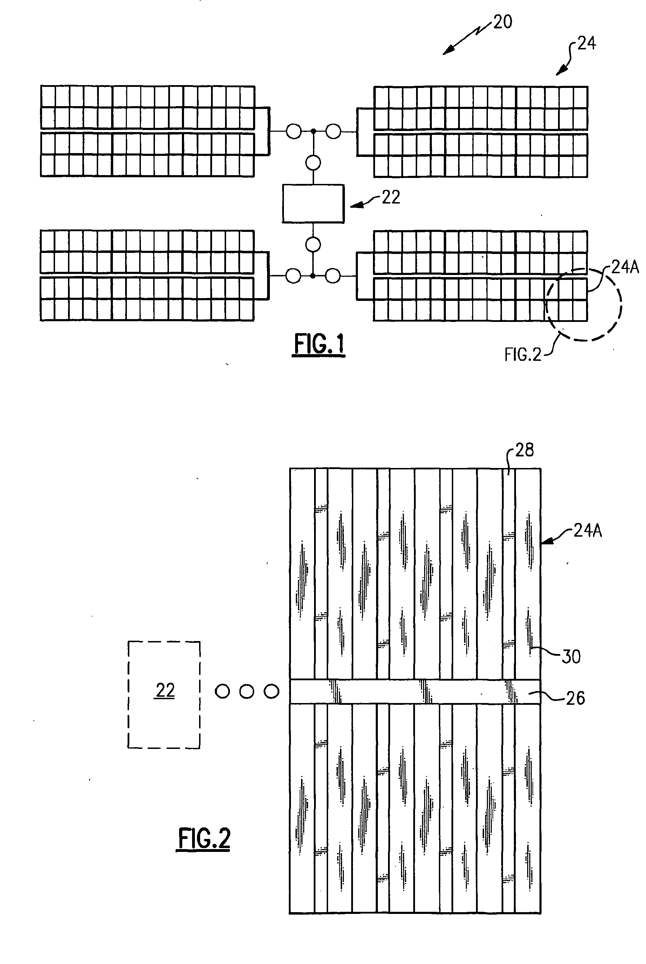

Figure 1 schematically illustrates an exemplary spacecraft 20 having a bus 22 and a wing structure 24 which extends therefrom. Although a particular spacecraft configuration is schematically illustrated and described in the disclosed non-limiting embodiment, other configurations will also benefit herefrom.

The wing structure 24 includes a multiple of wing panels 24A. Each wing panel 24A generally includes a support structure 26 which extends from the bus 22 to support a concentrator photovoltaic (CPV) array 28 which receives reflected sunlight from a segmented parabolic concentrator 30. (Figure 2).

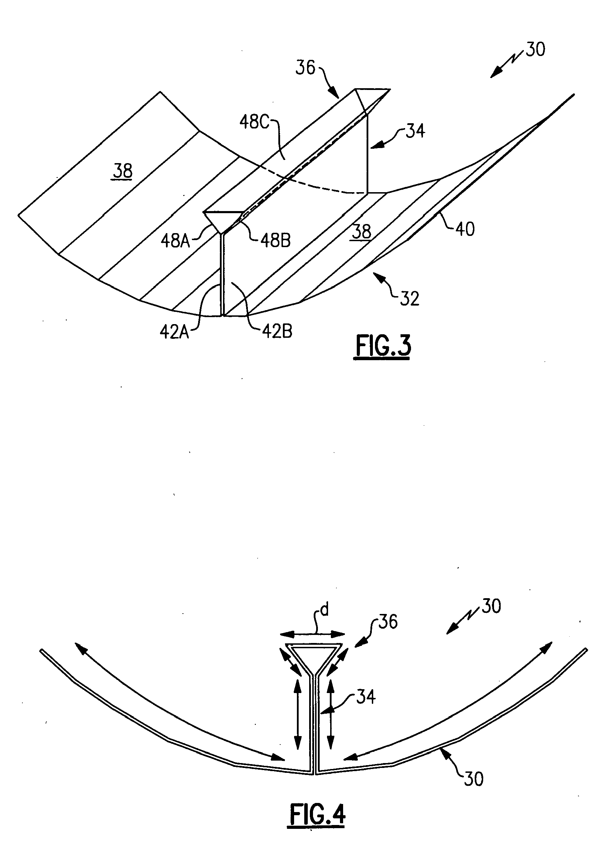

Referring to Figure 3, the segmented parabolic concentrator 30 generally includes a concave surface 32, a central support 34 and a cell support 36. The segmented parabolic concentrator 30 may be manufactured of a single carbon fiber laminate structure and the biased fiber direction of the carbon fiber laminate structure may be directed (illustrated schematically by arrow d in Figure 4) to control the modulus to density ratio and thermal conductivity to density ratio.

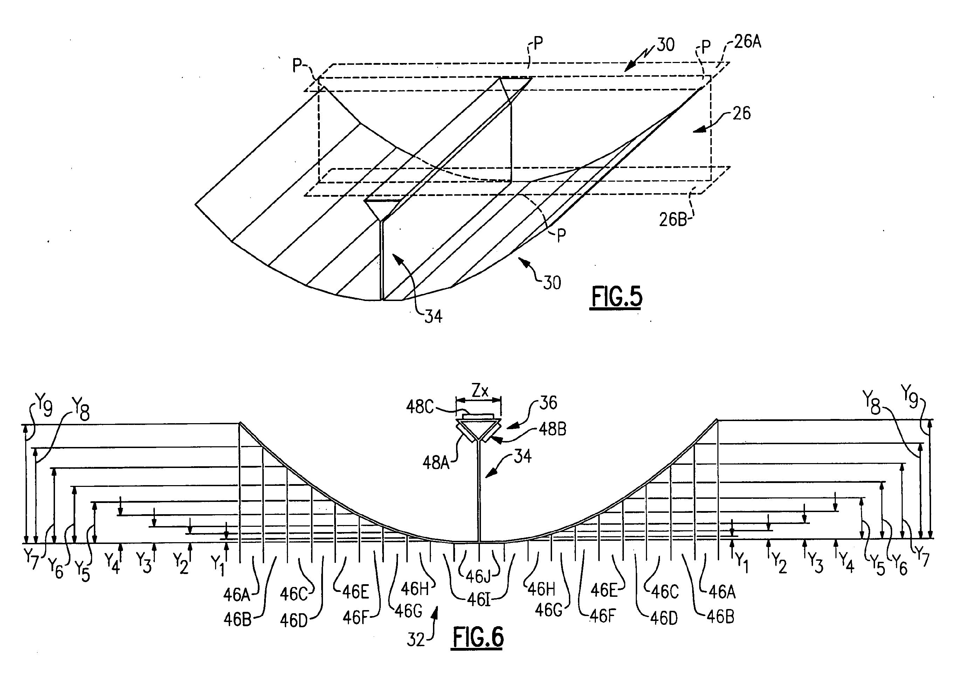

The central support 34 provides the stiffness required to meet deployed natural frequency requirements. The central support 34 also includes attachment points P which facilitate engagement with the support structure 26 (Figure 5). The attachment points P facilitate engagement at least partially within an I-shaped support structure 26 between a first and second beam surface 26A, 26B.

The segmented parabolic concentrator 30 includes coated areas for reflecting and radiating. A reflecting coated area 38 forms a mirrored or metalized reflecting front surface upon the concave surface 32. Radiating coated areas 40, 42A, 42B form blackened emitting surfaces on the back of the concave surface 32 and along the central support 34.

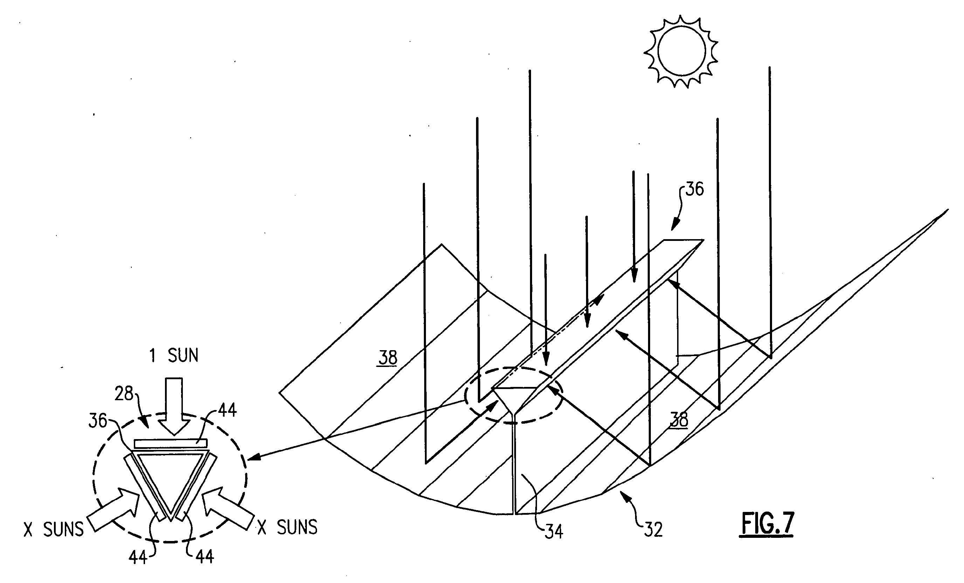

Referring to Figure 6, the concave surface 32 is formed as a multitude of flat segments 46. Each of the multitude of flat segments 46A-46J include the reflecting coated area 38 to concentrate a uniform distribution of sunlight onto a set of photo-voltaic cells 44 which form the CPV array 28 (Figure 7).

The cell support 36 may be generally triangular in cross-section to define facing sides 48A, 48B and a top side 48C to support the photo-voltaic cells 44. The shape of cell support 36 also provides a communication channel to facilitate packaging and connection for the wiring to the CPV array 28 through the central support 34. It should be understood that other cross-sectional shapes may alternatively or additionally provided.

The facing sides 48A, 48B define an approximately 90 degree angle in one non-limiting embodiment such that the photo-voltaic cells 44 of the CPV array 28 on the facing sides 48A, 48B receive a multiple of reflected sunlight from each of the multitude of flat segments 46A-46J of the concave surface 32 to convert sunlight to electricity. The facing sides 48A, 48B capture light at relatively moderate concentration ratios. The facing sides 48A, 48B concentration ratios reduce cell temperature and improve cell efficiency.

The top side 48C may include photo-voltaic cells 44 of the CPV array 28 that face the sun and convert direct sunlight to electricity. The top side 48C receives a one-sun concentration ratio to capture sunlight that would otherwise be shadowed which provides increased light collecting efficiency. Alternatively, the top side 48C may not include photo-voltaic cells 44 and include either a reflective or emitting coating. The cell support 36 may thereby operate as a radiator or reflector to further facilitate thermal management. The combined structure for support of the photo-voltaic cells 44 and thermal management results in minimal mass.

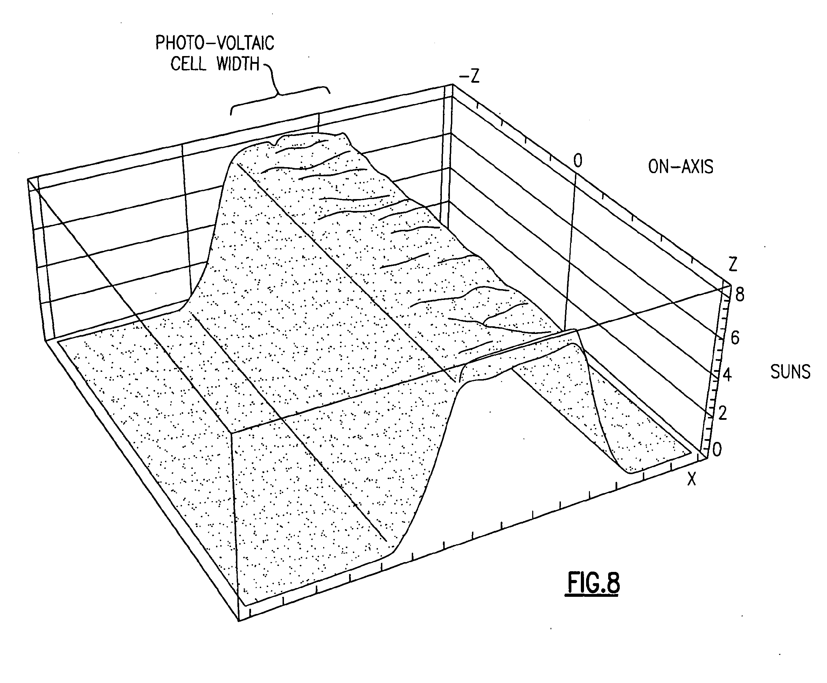

The multitude of flat segments 46 of the segmented parabolic concentrator 30 provides a more uniform light distribution than true parabolic surface to the photo-voltaic cells 44 (Figure 8). That is, each of the multitude of flat segments 46 direct light at a width generally equal to the width of the photo-voltaic cells 44. In one non-limiting embodiment, an algorithm for computing the height profile of the segmented parabolic concentrator 30 is given in the function "heightReflector", which uses the function "slopeReflector". The function slopeReflector, uses four inputs:
x, distance from the centerline of the profile;
f, the distance from the base of the profile to the center of the solar cell;
width, the desired total width of the reflector; and
nSeg, the number of segment in the reflector.

The output is the value of the slope, or increase in the profile height per unit increase in distance away from the centerline. The method of calculation is to calculate the required tilt that will reflect an incoming ray of direct sunlight towards the desired focal plane. The function "heightReflector" uses the same four inputs. The output is the height of the profile at a distance x from the centerline. The method of calculation is to start at a height of zero and integrate the slope of the reflector with respect to the distance coordinate from zero to the value of x. The two functions are shown below as coded in the Mathematica (TM) language as follows:

```
      slopeReflector=
        Compile[
          {{x,_Real},
          {f,_Real},
          {width,_Real},
          {nSeg,_Real}
          },
          Module[
            {k,
```

```
            xK
            },
           k=1+Quotient[Abs[x]-width/nSeg,width/nSeg];
           xK=k width/nSeg;
           xK;
           xK/(2 f) Sign[x]
          ]
        ]
```

```
      heightReflector=
        Compile[
          {{x,_Real},
          {f,_Real},
           {width,_Real},
         {nSeg,_Real}
          },
          Module[
            {k,
            dx,
            slopes,
            deltas
            },
           dx=width/nSeg;
           k=1+Quotient[Abs[x]-width/nSeg,width/nSeg];
            slopes=
             Table[
               slopeReflector[j width/nSeg,f,width,nSeg],
               {j,0,k}
             ];
            Apply[
             Plus,
             slopes dx
```

```
           ]+
          (Abs[x]-(k+1) dx)slopes[[k+1]]
         ],
         {{slopeReflector[_,_,_,J,_Real}}]
```

The multitude of flat segments 46 have an equal horizontal component in one non-limiting embodiment such that the width of the reflected light from each of the multitude of flat segments 46 is approximately equal to the width of the photo-voltaic cells 44. That is, each of the multitude of flat segments 46 extend perpendicular from the central support 34 for an equal horizontal component approximately equivalent to the width of the photo-voltaic cells 44 while the vertical component directs the sunlight onto the width of the photo-voltaic cells 44. For example, one of the multitude of flat segments 46A which is directly opposed or parallel to the facing sides 48A, 48B of the central support 34 is arranged at 45 degrees relative to the horizontal so as to direct sunlight onto the photo-voltaic cells 44. The light is thereby distributed relatively uniformly over a flat plane (Figure 8) as compared to a conventional parabolic reflector which focuses light generally along a line.

Each of the multitude of flat segments 46 reflects approximately one sun onto the photo-voltaic cells 44. The number of flat segments 46 controls the concentration ratio such that, for example, eight segments deliver the light equivalent of eight suns.

The segmented parabolic concentrator 30 provides relatively even light distribution on and off-axis which results in relatively greater photo-voltaic cells 44 efficiency due to a more even temperature distribution. A relatively short light path to the photo-voltaic cells 44 provides improved off-pointing power and less sensitivity to structural distortions. The composite materials also facilitate less mass for the same strength and thermal gradients so as to provide a lightweight power and propulsion system capable of providing responsive spacecraft maneuverability for on-orbit servicing, space-based situational awareness, and high-power payloads such as communication and radar systems.

It should be understood that like reference numerals identify corresponding or similar elements throughout the several drawings. It should also be understood that although a particular component arrangement is disclosed in the illustrated embodiment, other arrangements will benefit herefrom.

The foregoing description is exemplary rather than defined by the limitations within. Various non-limiting embodiments are disclosed herein, however, one of ordinary skill in the art would recognize that various modifications and variations in light of the above teachings will fall within the scope of the appended claims. It is therefore to be understood that within the scope of the appended claims, the disclosure may be practiced other than as specifically described. For that reason the appended claims should be studied to determine true scope and content.

## Claims

1. A segmented parabolic concentrator (30) comprising:
a cell support (36);
a central support (34) which extends from said cell support; and
a concave surface (32) which extends from said central support, said concave surface defining a multitude of flat segments (46).

2. The segmented parabolic concentrator as recited in claim 1 including a concentrator photo-voltaic (CPV) array (44) mounted on said cell support and operable to receive reflected sunlight from said concave surface.

3. The segmented parabolic concentrator as recited in claim 1 or 2, wherein each of said multitude of flat segments (46) is directed toward said cell support.

4. The segmented parabolic concentrator as recited in claim 1, 2 or 3, wherein said cell support (36) is triangular in lateral cross-section.

5. The segmented parabolic concentrator as recited in claim 4, further comprising at least one photo-voltaic cell (44) on a first surface (48A) of said cell support and at least one photo-voltaic cell on a second surface (48B) of said cell support, said first surface and said second surface facing said concave surface (32).

6. The segmented parabolic concentrator as recited in claim 5, wherein said first surface (48A) and said second surface (48B) define an approximately ninety degree angle therebetween.

7. The segmented parabolic concentrator as recited in any preceding claim, wherein said central support (34) includes a radiating coated area to form a blackened emitting surface.

8. The segmented parabolic concentrator as recited in any preceding claim, wherein said concave surface (32) includes a radiating coated area to form a blackened emitting surface on a backside thereof.

9. The segmented parabolic concentrator as recited in any preceding claim, wherein each of said multitude of flat segments (46) has an equal horizontal component.

10. A wing structure (24) for a spacecraft comprising:
a segmented parabolic concentrator (30) which defines a multitude of flat segments; and
a concentrator photovoltaic (CPV) array (44) operable to receive reflected sunlight from said segmented parabolic concentrator.

11. The wing structure as recited in claim 10, wherein each of said multitude of flat segments (46) has an equal horizontal component.

12. The wing structure as recited in claim 10 or 11, further comprising a support structure (26), said segmented parabolic concentrator being transverse to said support structure.

13. The wing structure as recited in claim 10, 11 or 12, wherein said concentrator photovoltaic (CPV) array (44) is supported on a cell support (36), said cell support being supported on a central support (34) which extends from said segmented parabolic concentrator.

14. The wing structure as recited in claim 13, wherein said cell support (36) is triangular in lateral cross-section.

15. The wing structure as recited in claim 14, further comprising at least one photo-voltaic cell (44) on a first surface (48A) of said cell support and at least one photo-voltaic cell on a second surface (48B) of said cell support, said first surface and said second surface facing said concave surface (32); preferably
wherein said first surface (48A) and said second surface (48B) define an approximately ninety degree angle therebetween.
